# EUROPEAN PATENT APPLICATION

(11) **EP 2 506 319 A2**
(43) Date of publication of application: **03.10.2012**
(21) Application number: 12162342.5
(22) Date of filing: 30.03.2012
(51) Int. Cl.: H01L 33/46, H01L 33/44, H01L 27/15

(54) **Semiconductor light emitting device and head mount display device**

(30) Priority: 31.03.2011 JP 2011077138
(71) Applicant: Oki Data Corporation, Tokyo 108-8551 (JP)
(72) Inventor: Jumonji, Shinya, Takasaki-shi, Gunma 370-0021 (JP); Suzuki, Takahito, Takasaki-shi, Gunma 370-0021 (JP)
(74) Representative: Betten & Resch

(57) **Abstract**

A semiconductor light emitting device (1) includes a thin-film semiconductor light emitting element (31), a substrate (21), a first insulation layer (13) having a surface to which the thin-film semiconductor light emitting element is bonded, a first metal layer (11) composed of aluminum and disposed on a side of the first insulation layer (12) facing the substrate, and a second insulation layer disposed between the first insulation layer and the first metal layer.

## Description

### BACKGROUND OF THE INVENTION

The present invention relates to a semiconductor light emitting device including a thin-film light emitting element, and a head mount display device including the semiconductor light emitting device.

There is known a semiconductor light emitting device including a single-crystal thin-film semiconductor light emitting element (for example, a thin-film LED) that emits light from both sides. A metal layer is provided on a backside (i.e., a substrate side) of the single-crystal semiconductor light emitting element. The metal layer reflects light emitted from the backside of the single-crystal semiconductor light emitting element. With such a configuration, light emitted from a surface side (i.e., a top side) of the single-crystal semiconductor light emitting element and light emitted from the backside of the single-crystal semiconductor light emitting element and reflected by the metal layer are both emitted from the surface side of the semiconductor light emitting device. Therefore, the semiconductor light emitting device can emit light with high intensity.

The metal layer is composed of Al (aluminum) that reflects light having wavelengths covering red, green and blue light (i.e., three primary colors) and has reflectance of 90% or more. In comparison, Au has reflectance of 95% or more for light having longer wavelength (for example, red light), but has 50% or less for light having shorter wavelength (particularly, light whose wavelength is shorter than 550 nm such as green and blue light).

Japanese Laid-open Patent Publication No. 2004-179641 discloses a manufacturing method of a semiconductor light emitting device called as "Epi Film Bonding". In this method, a plurality of single-crystal semiconductor light emitting elements are pressed against an insulation layer provided on a substrate, so that the single-crystal semiconductor light emitting elements are directly bonded to the insulation layer by means of hydrogen bonding. This method is advantageous in reducing cost and size of the semiconductor light emitting device.

In order to apply this method, it is necessary to form an insulation layer such as an organic insulation layer on the metal (Al) layer for bonding the single-crystal semiconductor light emitting elements.

However, the Al layer is formed by vapor deposition, sputtering or the like. When the Al layer is subjected to heat during manufacturing process, hillocks (protrusions) may be formed on a surface of the Al layer due to a difference in thermal expansion coefficient.

If such hillocks are formed on the surface of the metal (Al) layer, the insulation layer formed on the metal layer may have a roughness of, for example, several tens of nanometers or more. In such a case, the single-crystal semiconductor light emitting elements cannot be bonded to the insulation layer.

### SUMMARY OF THE INVENTION

An aspect of the present invention is intended to provide a semiconductor light emitting device including a thin-film semiconductor light emitting element bonded to an insulation layer, and a head mount display including the semiconductor light emitting device.

According to an aspect of the present invention, there is provided a semiconductor light emitting device including a thin-film semiconductor light emitting element, a substrate, a first insulation layer having a surface to which the thin-film semiconductor light emitting element is bonded, a first metal layer composed of aluminum and disposed on a side of the first insulation layer facing the substrate, and a second insulation layer disposed between the first insulation layer and the first metal layer.

With such a configuration, the thin-film semiconductor light emitting element can be bonded to the first insulation layer even when hillocks are formed on the first metal layer.

According to another aspect of the present invention, there is provided a head mount display device including the above described semiconductor light emitting device.

Further scope of applicability of the present invention will become apparent from the detailed description given hereinafter. However, it should be understood that the detailed description and specific embodiments, while indicating preferred embodiments of the invention, are given by way of illustration only, since various changes and modifications within the spirit and scope of the invention will become apparent to those skilled in the art from this detailed description.

### BRIEF DESCRIPTION OF THE DRAWINGS

In the attached drawings:
FIG. 1 is a plan view showing a light emitting device having a semiconductor light emitting device according to the first embodiment of the present invention;
FIGS. 2A and 2B are sectional views of the light emitting device respectively taken along line 2A-2A and line 2B-2B in FIG. 1;
FIG. 3 is a schematic view showing the semiconductor light emitting device in which first and second insulation layers are formed on a metal layer on which hillocks are formed;
FIG. 4A is a schematic sectional view showing a semiconductor epitaxial wafer for forming an LED epitaxial film according to the first embodiment of the present invention;
FIG. 4B is a schematic sectional view showing an etching process for separating the LED epitaxial film from an epitaxial growth substrate according to the first embodiment of the present invention;
FIG. 4C is a schematic sectional view showing the LED epitaxial film separated from the epitaxial growth substrate according to the first embodiment of the present invention;
FIGS. 5A and 5B are schematic sectional views respectively showing a blue thin-film LED and a red thin-film LED according to the first embodiment of the present invention;
FIG. 6 is a sectional view showing a semiconductor light emitting device according to the second embodiment of the present invention;
FIG. 7, is a sectional view showing a semiconductor light emitting device according to the third embodiment of the present invention;
FIG. 8 is a schematic view showing a head mount display to which the semiconductor light emitting device according to the first, second or third embodiment is mounted.

### DETAILED DESCRIPTION OF THE PREFERRED EMBODIMENT

Hereinafter, embodiments of the present invention will be described with reference to drawings.

### FIRST EMBODIMENT.

### <Light Emitting Device>

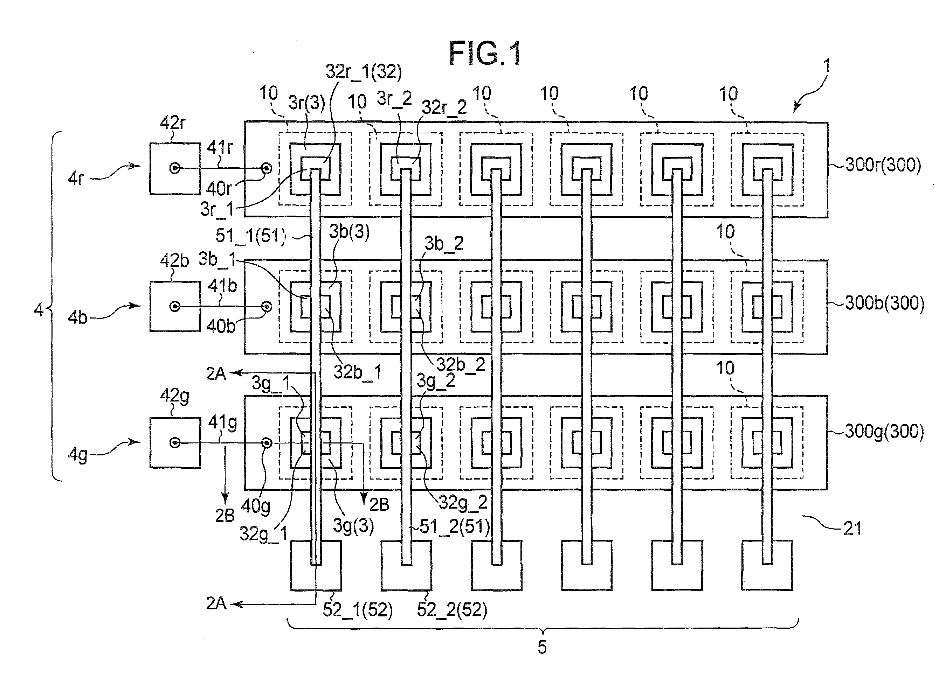

FIG. 1 is a plan view showing a light emitting device 1 as a semiconductor light emitting device according to the first embodiment of the present invention. The light emitting device 1 shown in FIG. 1 includes a semiconductor light emitting portions 10 of red, green and blue. The light emitting device 1 is configured so that the semiconductor light emitting portions 10 emit light under control of a controller (not shown).

The light emitting device 1 includes a substrate 21. The light emitting device 1 further includes a plurality of semiconductor light emitting portions 10, a cathode driving circuit 4 and an anode driving circuit 5 provided on the substrate 21. Each semiconductor light emitting portion 10 has a thin-film LED (Light Emitting Diode) 3 as a thin-film semiconductor light emitting element. The cathode driving circuit 4 is connected to cathode electrodes of the thin-film LEDs 3 via wires 41 and cathode connection pads 42 described later. The anode driving circuit 5 is connected to anode electrodes of the thin-film LEDs 3 via common anode wirings 51 and anode connection pads 52 described later. With such connections, current paths are formed. The anode wirings 51 are composed of thin-film metal.

In this embodiment, the semiconductor light emitting portions 10 that have the thin-film LEDs 3 of the same color are arranged on the same line (i.e., row) on the substrate 21. Each semiconductor light emitting portion 10 has one of the red thin-film LED 3r, the blue thin-film LED 3b and the green thin-film LED 3g, The red thin-film LED 3r emits light having wavelengths corresponding to red color, the blue thin-film LED 3b emits light having wavelengths corresponding to blue color, and the green thin-film LED 3g emits light having wavelengths corresponding to green color.

In an example shown in FIG. 1, the red thin-film LEDs 3r (3r_1, 3r_2 ...) are linearly arranged along a first row. The blue thin-film LEDs 3b (3b_1, 3b_2 ...) are linearly arranged along a second row. The green thin-film LEDs 3g (3g_1, 3g_2 ...) are linearly arranged along a third row. The rows of the thin-film LED 3 are parallel to each other. Further, corresponding thin-film LEDs 3 of respective rows are linearly arranged along a line (column). For example, the red thin-film LEDs 3r_1, the blue thin-film LEDs 3b_1, and the green thin-film LEDs 3g_1 are linearly arranged along a first column.

Cathode electrodes 40 (40r, 40b and 40g) are provided for respective groups (rows) of the thin-film LEDs 3r, 3b and 3g. More specifically, the cathode electrode 40r is provided commonly for the red thin-film LEDs 3r (3r_1, 3r_2 ...). The cathode electrode 40b is provided commonly for the blue thin-film LEDs 3b (3b_1, 3b_2 ...). The cathode electrode 40g is provided commonly for the green thin-film LEDs 3g (3g_1, 3g_2 ...).

With such an arrangement, the number of wirings can be reduced as compared with a case where the cathode electrodes 40 are provided for respective thin-film LEDs 3, and therefore space can be saved.

The thin-film LEDs 3 of three colors arranged along the same columns are connected to common anode wirings 51 (51_1, 52_2 ...) at anode electrodes 32. More specifically, the anode electrode 32r_1 of the red thin-film LED 3r_1, the anode electrode 32b_1 of the blue thin-film LED 3b_1, and the anode electrode 32g_1 of the green thin-film LED 3g_1 are connected to an anode wiring 51_1. Similarly, the anode electrode 32r_2 of the red thin-film LED 3r_2, the anode electrode 32b_2 of the blue thin-film LED 3b_2, and the anode electrode 32g_2 of the green thin-film LED 3g_2 are connected to an anode wiring 51_2.

### <Cathode Driving Circuit>

The cathode electrode 4 electrically connects and disconnects between the cathode connection pads 42 (42r, 42b, 42g) and negative terminals of electric current sources (not shown) under control of the controller. In a state where the anode driving circuit 5 is turned ON as described later, when the cathode driving circuit 4 is turned ON, the cathode connection pad 42 and the anode connection pad 52 are electrically connected, and current flows through the thin-film LED 3 via the cathode connection pad 42.

The cathode driving circuit 4 includes a red cathode driving circuit 4r, a blue cathode driving circuit 4b and a green cathode driving circuit 4g.

The red cathode driving circuit 4r is connected to the cathode electrode 40r of the red thin-film LEDs 3r via a red cathode connection pad 42r and a wire 41r. With this connection, current flows from the red cathode driving circuit 4r to the cathode electrode 40r of the red thin-film LEDs 3r. Similarly, the blue cathode driving circuit 4b is connected to the cathode electrode 40b of the blue thin-film LEDs 3b via a blue cathode connection pad 42b and a wire 41b. The green cathode driving circuit 4g is connected to the cathode electrode 40g of the thin-film LEDs 3g via a green cathode connection pad 42g and a wire 41g.

### <Anode Driving Circuit>

The anode driving circuit 5 electrically connects and disconnects between the anode connection pads 52 and positive terminals of electric current sources (not shown) under control of the controller. In a state where the cathode driving circuit 4 is turned ON, when the anode driving circuit 5 is turned ON, the cathode connection pad 42 and the anode connection pad 52 are electrically connected, and current flows through the thin-film LED 3.

The anode driving circuit 5 includes anode wirings 51 (51_1, 51_2 ...) each of which is connected to the anode electrodes 32 of the thin-film LEDs 3 of three colors linearly arranged, and the anode connection pads 52 (52_1, 52_2 ...) connected to the respective anode wirings 51.

Each anode wiring 51 is connected to the anode electrodes 32r, 32b and 32g of the red thin-film LEDs 3r, the blue thin-film LED 3b and the green thin-film LED 3g which are linearly arranged. For example, the anode wiring 51_1 is connected to the anode electrode 32r_1 of the red thin-film LED 3r_1, the anode electrode 32b_1 of the blue thin-film LED 3b_1, the anode electrode 32g_1 of the green thin-film LED 3g_1 and the anode connection pad 52_1.

With such a configuration, for example, when the blue cathode driving circuit 4b and the anode driving circuit 5 are controlled by the controller so that the blue cathode connection pad 42b and the anode connection pad 52_1 are connected to the electric current source under control of the controller (not shown), current flows into the anode electrode 32b_1 of the blue thin-film LED 3b_1 via the anode connection pad 52_1 and the anode wiring 51_1. Further, current flows from the cathode electrode 40b_1 to the blue cathode driving circuit 4b via the wire 41b and the blue cathode connection pad 42b. Therefore, the blue thin-film LED 3b_1 emits light.

In this state, when the red cathode driving circuit 4r and the green cathode driving circuit 4g are controlled by the controller so that the red cathode connection pad 42r and the anode connection pad 52_1 are connected to the electric current source and the green cathode connection pad 42g and the anode connection pad 52_1 are connected to the electric current source, the red thin-film LED 3r_1 and the green thin-film LED 3g_1 emit light.

### <Semiconductor Light Emitting Portion>

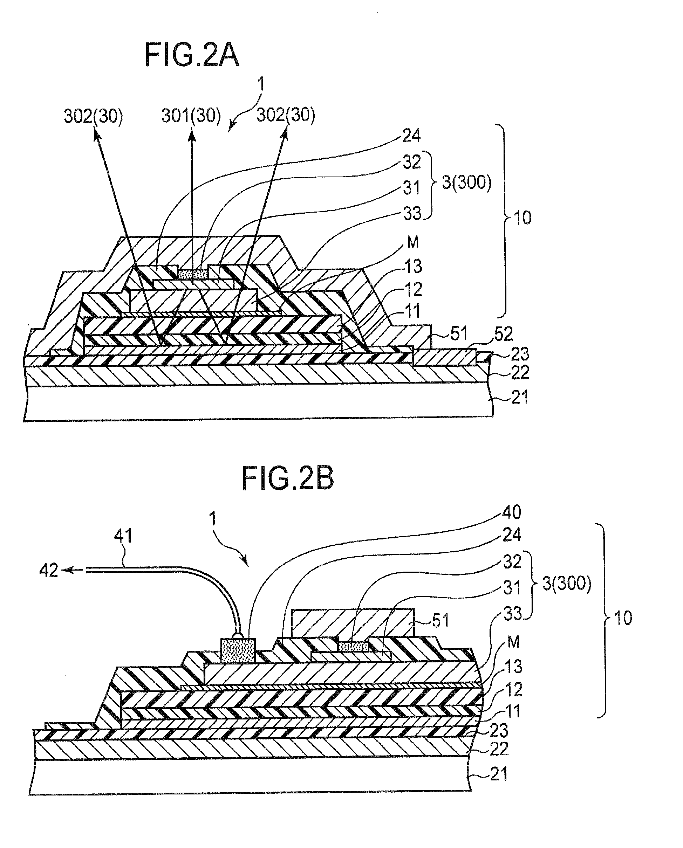

FIG. 2A is a sectional view of the light emitting device according to the first embodiment taken along line 2A-2A in FIG. 1. FIG. 2B is a sectional view of the light emitting device according to the first embodiment taken along line 2B-2B in FIG. 1.

As shown in FIGS. 2A and 2B, the semiconductor light emitting portion 10 of the light emitting device 1 includes an interlayer insulation layer 24, a light emitting layer 31, the anode electrode 32, a semiconductor thin film 33, a conductive layer M, a metal layer 11, a second insulation layer 12, and a first insulation layer 13. In this regard, the light emitting layer 31, the anode electrode 32 and the semiconductor thin film 33 constitute a thin-film LED 3. The semiconductor light emitting portion 10 is provided on a base insulation layer 23 covering an integrated circuit region 22 provided on the substrate 21. The substrate 21 is composed of Si (silicon) or the like. The integrated circuit region 22 includes ICs (i.e., integrated circuits) provided on the substrate 21.

The base insulation layer 23 is a passivation layer for preventing electrical short-circuiting between the metal layer 11 and the integrated circuit region 22. The base insulation layer 23 partially or entirely covers the integrated circuit region 22 except at least a portion where the anode connection pad 52 is connected to the anode wiring 51. The base insulation layer 23 is, for example, a SiN (silicon nitride) film formed by a P-CVD (Plasma Chemical Vapor Deposition) method.

The metal layer 11 is formed on a surface of the base insulation layer 23 facing away from the substrate 21. The metal layer 11 reflects light emitted from a surface (i.e., a lower surface in FIG. 2A) of the thin-film LED 3 facing the substrate 21. The thin-film LED 3 is bonded to a surface (i.e., an upper surface in FIG. 2A) of the metal layer 11 facing away from the substrate 21, via the first insulation layer 13 and the second insulation layer 12. Further, the cathode electrode 40 (i.e., an n-side electrode) is provided on the semiconductor thin film 33. The interlayer insulation layer 24 is formed so as to entirely cover a part of the thin-film LED 3 (except the anode electrode 32 and the cathode electrode 40), the insulation layers 12 and 13 and the metal layer 11.

With such a configuration, light 30 (301) is emitted from a surface (i.e., an upper surface in FIG. 2A) of the thin-film LED 3 facing away from the substrate 21. Further, light 30 (302) is emitted from the surface (i.e., the lower surface in FIG. 2A) of the thin-film LED 3 facing the substrate 21, reflected by the metal layer 11, and is emitted through the surface of the thin-film LED 3 facing away from the substrate 21. Therefore, light emitted by the thin-film LED 3 is effectively taken out.

### <Interlayer Insulation Layer>

The interlayer insulation layer 24 is provided for preventing electrical short-circuiting between the anode wiring 51 and the metal layer 11. Further, the interlayer insulation layer 24 transmits light. For example, the interlayer insulation layer 24 is formed of SiN (Silicon Nitride) film, which is the same material as that of the base insulation layer 23.

### <Metal Layer>

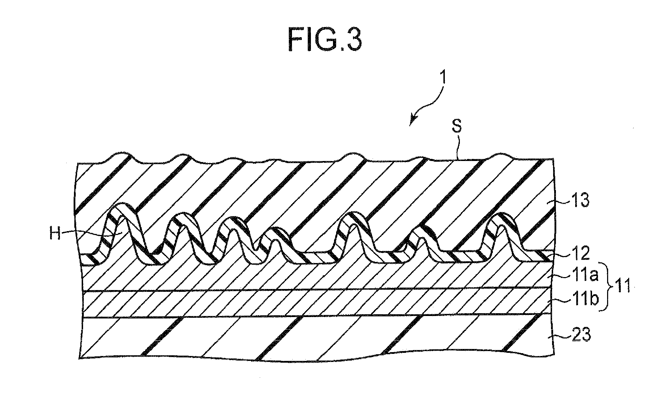

The metal layer 11 is a reflection layer that reflects light 302 emitted by the thin-film LED 3. The metal layer 11 includes a first metal layer 11a composed of Al (aluminum), and a second metal layer 11b composed of Ti (titanium) as shown in FIG. 3. The metal layer 11 is formed by vapor deposition or sputtering, and has a thickness of less than 1 µm.

FIG. 3 is a schematic view showing the base insulation layer 23, the metal layer 11 and the insulation layers 12 and 13 in an enlarged scale.

The second metal layer 11b (Ti) is a diffusion prevention layer for preventing diffusion of Al of the first metal layer. Since a melting point of Al is 660 °C, diffusion of Al may be caused by heat during manufacturing of the light emitting device 1. Therefore, the second metal layer 11b composed of Ti having a melting point (1660 °C) higher than Al is provided below the first metal layer 11a (Al) so as to prevent diffusion of Al of the first metal layer.

The first metal layer 11a (Al) is a reflection layer that reflects light emitted by the surface of the thin-film LED 3 facing the substrate 21. The second metal layer 11b (Ti) is disposed on the substrate 21 side (i.e., a lower side in FIG. 3) of the first metal layer 11a (Al). In other words, the first metal layer 11a (Al) is disposed on a side (i.e., an upper side in FIG. 3) of the second metal layer 11b (Ti) facing away from the substrate 21.

When the first metal layer (Al) is subjected to heat during deposition or sputtering process, Al crystals may abnormally grow, with the result that protrusions may be formed on the surface of the first metal layer (Al). Such protrusions are referred to as hillocks H. If a large number of hillocks H are formed, the surface of the first metal layer (Al) may have a surface roughness such that the thin-film LED 3 (semiconductor thin film 33) cannot be directly bonded to the surface of the first metal layer 11. The hillocks are generated due to a difference in thermal expansion coefficient of material of the metal layer. At a room temperature of 20°C, a linear expansion coefficient of Al is 23.1 × 10⁻⁶ (1/K), a linear expansion coefficient of Au is 14.2 × 10⁻⁶ (1/K), and a linear expansion coefficient of Ti is 8.6 × 10⁻⁶ (1/K).

Therefore, in the first embodiment, the thin-film LED 3 (i.e., an LED epitaxial film 300) is provided on the metal layer 11 via two insulation layers 12 and 13. This configuration is obtained by forming the insulation layers (i.e., the second insulation layer 12 and the first insulation layer 13) on the metal layer 11, and directly bonding an LED epitaxial film 300 (i.e., the thin-film LED 3) to the first insulation layer 13 by means of hydrogen bonding (i.e., a method called "Epi Film Bonding"). Detailed description will be made later.

### <Insulation Layers>

The insulation layers (i.e., the second insulation layer 12 and the first insulation layer 13) are formed on the surface (i.e., the upper surface in FIG. 3) of the metal layer 11 facing away from the substrate 21 so as to cover the hillocks H formed on the metal layer 11. The insulation layers are formed so as to reduce a surface roughness of the first insulation layer 13, i.e., to planarize the first insulation layer 13. The second insulation layer 12 and the first insulation layer 13 are configured to transmit light. Further, the second insulation layer 12 and the first insulation layer 13 prevent electrical short-circuiting between the metal layer 11 and the conductive layer M. In this regard, FIG. 3 is a conceptual diagram, and therefore hillocks H are illustrated on a larger scale as they are.

The second insulation layer 12 is composed of an inorganic insulation film. For example, the second insulation layer 12 is preferably formed of SiN. The second insulation layer 12 is formed into a constant thickness on the surface (i.e., the upper surface in FIG. 3) of the metal layer 11 facing away from the substrate 21 using the P-CVD (Plasma Chemical Vapor Deposition) method. Preferably, a maximum thickness of the second insulation layer 12 is approximately 110 nm. Since the second insulation layer 12 is formed by the P-CVD method, the second insulation layer 12 having a constant thickness is formed so as to cover the surface of the hillock H in a seamless (continuous) manner. In other words, a step coverage effect is obtained.

The first insulation layer 13 is composed of an organic insulation film. For example, the first insulation layer 13 is preferably formed of polyimide resin, fluorine based resin or the like. The first insulation layer 13 is formed by a spin coating method. Since the first insulation layer 13 is formed of a resin spin coated onto the second insulation layer 12, a surface of the first insulation layer 13 is planarized. The first insulation layer 13 can be made thicker than the second insulation layer 12. Preferably, a maximum thickness of the first insulation layer 13 is approximately 1.5 µm.

A total thickness of the insulation layers (i.e., the first insulation layer 13 and the second insulation layer 12) formed on the metal layer 11 is preferably in a range from 1.5 µm to 1.7 µm (and the most preferably, 1.6 µm). With this range, the insulation layers 12 and 13 can cover the hillocks H on the surface of the metal layer 11, and a surface roughness of a surface S of the first insulation layer 13 can be lower than or equal to 20 nm, even when the hillocks H have height of approximately 100 nm, i.e., even when the surface roughness of the second insulation layer 12 is approximately 100 nm. Since the surface roughness of the first insulation layer 13 is lower than or equal to several tens of nm, an N-type region of the thin-film LED 3 (i.e., the semiconductor thin film 33) can be bonded to the first insulation layer 13 using the method called as "Epi Film Bonding" as described later.

Here, description will be made to materials of the insulation layers 12 and 13. First, contrary to the first embodiment, it is assumed that the second insulation layer 12 is formed of an organic insulation film and the first insulation layer 13 is formed of inorganic insulation film. In such a case, steps (unevenness) or discontinuities of the organic insulation film may occur, and voids (empty spaces) may be formed between the organic insulation film and the hillocks on the surface of the metal layer 11. Such voids make it difficult to eliminate the steps caused by the hillocks H. Further, if the first insulation layer 13 of inorganic insulation film is formed using the P-CVD method, there is a possibility that the hillocks H on the metal layer 11 may grow depending on heating temperature. Therefore, as the first insulation layer 13 is made thicker (for covering the hillocks H on the metal layer 11), the hillocks H on the metal layer 11 may grow larger. In order to cover the hillocks H, it is necessary to further increase the thickness of the first insulation layer 13.

In contrast, according to the first embodiment, the second insulation layer 12 is formed of an inorganic insulation film and the first insulation layer 13 is formed of an organic film. The second insulation layer 12 (i.e., the inorganic insulation film) can be formed using the P-CVD method. The first insulation layer 13 (i.e., the organic insulation film) can be formed on the second insulation layer 12 after the hillocks H are covered by the second insulation layer 12. Accordingly, the insulation layers 12 and 13 can be formed so as to cover the metal layer 11 without forming voids.

### <LED Epitaxial Film>

The LED epitaxial film 300 is a sheet-like semiconductor thin film. A plurality of the thin-film LEDs 3 of the same color are formed on the same LED epitaxial film 300 as shown in FIG. 1. The thin-film LEDs 3 are arranged in a line (row) at a constant interval on each of the LED epitaxial films 300.

More specifically, a red LED epitaxial film 300r having red thin-film LEDs 3r (3r_1, 3r_2 ...), a blue LED epitaxial film 300b having blue thin-film LEDs 3b (3b_1, 3b_2 ...) and a green LED epitaxial film 300 having green thin-film LEDs 3g (3g_1, 3g_2 ...) are provided on the substrate 21.

### <Manufacturing Method of LED Epitaxial Film>

Here, a manufacturing method of the LED epitaxial film 300 will be described.

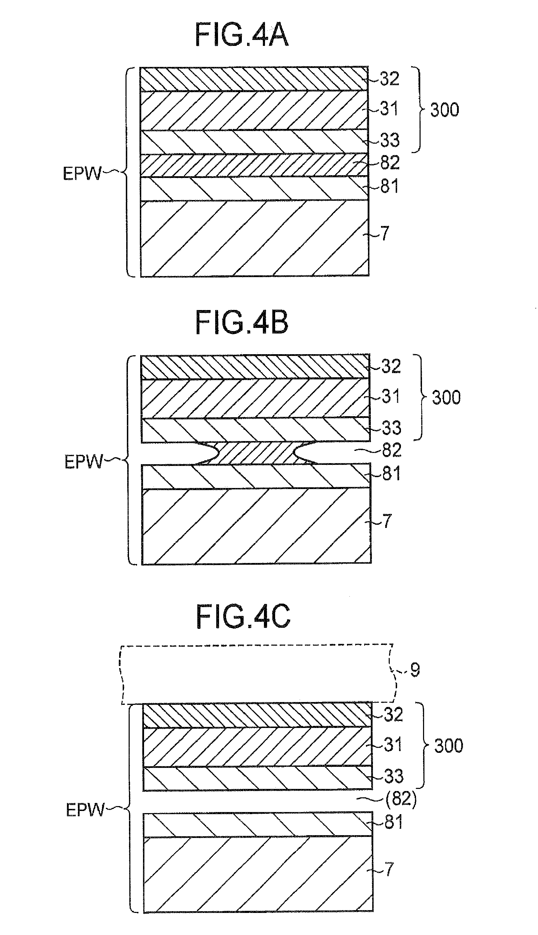

FIGS. 4A, 4B and 4C are schematic sectional views for illustrating the manufacturing process of the LED epitaxial film 300.

FIG. 4A is a schematic sectional view showing a semiconductor epitaxial wafer EPW for forming the LED epitaxial film 300. FIG. 4B is a schematic sectional view showing an etching process for separating the LED epitaxial film 300 from an epitaxial growth substrate 7. FIG. 4C is a schematic sectional view showing the LED epitaxial film 300 separated from the epitaxial growth substrate 7.

In FIG. 4A, the epitaxial growth substrate 7 is provided for growing epitaxial semiconductor layers thereon. A buffer layer 81, a separation layer 82 and the LED epitaxial film 300 are formed on the epitaxial growth substrate 7 in this order. The separation layer 82 (i.e., a sacrificial layer) is provided for separating the LED epitaxial film 300 from the epitaxial growth substrate 7. The LED epitaxial film 300 includes a semiconductor thin film 33, a light emitting layer 31 and an anode electrode 32. The semiconductor thin film 33 contacts the separation layer 82.

An etching speed of the separation layer 82 by etching solution or the like is faster than etching speeds of the LED epitaxial film 300 and the epitaxial growth substrate 7. Etching speeds of the semiconductor thin film 33, the light emitting layer 31 and the anode electrode 32 of the LED epitaxial film 300 by etching solution or the like are slower than the etching speed of the separation layer 82. That is, the semiconductor thin film 33, the light emitting layer 31 and the anode electrode 32 are not etched during an etching process of the separation layer 82.

In the manufacturing process of the LED epitaxial film 300, the separation layer 82 of the semiconductor epitaxial wafer EPW is selectively etched using a difference in etching speed as shown in FIG. 4B. Then, the LED epitaxial film 300 above the separation layer 82 is separated from the epitaxial growth substrate 7 as shown in FIG. 4C.

In the separation process, the LED epitaxial film 300 is supported by, for example, a supporting body 9 which has been previously formed on the LED epitaxial film 300.

### <Thin-Film LED>

Thin-film LED 3 is a single-crystal semiconductor light emitting element formed on the LED epitaxial film 300. As shown in FIGS. 2A and 2B, the conductive layer M is formed on the first insulation layer 13, and the thin-film LED 3 is formed on the conductive layer M. The red thin-film LED 3r is formed on the red LED epitaxial film 300r, the blue thin-film LED 3b is formed on the blue LED epitaxial film 300b, and the green thin-film LED 3g is formed on the green LED epitaxial film 300g.

### <Conductive Layer>

The conductive layer M has a function as an adhesive agent for bonding the LED epitaxial film 300 (more specifically, the semiconductor thin film 33) and the first insulation layer 13. The conductive layer M is composed of metal, and is sufficiently thin so that the conductive layer M transits light. For example, the conductive layer M is composed of gold (Au) or the like.

In this regard, when the surface S of the first insulation layer 13 is lower than or equal to 5 nm, the semiconductor thin film 33 can be directly bonded to the first insulation layer 13 using hydrogen bonding without using the conductive layer M or other adhesive agent. In such a case, the conductive layer M shown in FIGS. 2A and 2B can be eliminated.

### <Configuration of Thin-Film LED>

A configuration of the thin-film LED 3 will be described. In this regard, configurations of the blue thin-film LED 3b and the green thin-film LED 3g will be first described, and then a configuration of the red thin-film LED 3r will be described.

### <Configurations of Blue and Green Thin-Film LEDs>

The configuration of the blue thin-film LED 3b will be herein described. The configuration of the green thin-film LED 3g is similar to that of the blue thin-film LED 3b, and therefore description of the configuration of the green thin-film LED 3g will be omitted.

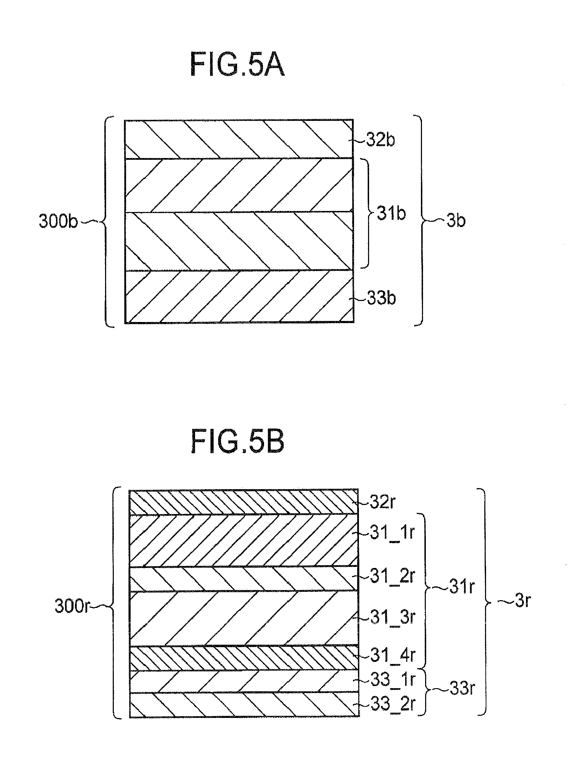

FIG. 5A is a schematic sectional view showing the blue thin-film LED 3b. As shown in FIG. 5A, the blue thin-film LED 3b has a laminate structure, and includes a semiconductor thin film 33b, a light emitting layer 31b and an anode electrode 32b. The semiconductor thin film 33b is formed of a layer composed of GaN (gallium nitride). The light emitting layer 31b is formed of two layers, i.e., an N-type semiconductor layer composed of GaN and an active layer composed of InGaN (Indium Gallium Nitride) formed on the N-type semiconductor layer. The anode electrode 32b is a P⁺ contact layer of GaN.

The blue thin-film LED 3b is configured so that the N-type semiconductor layer (GaN) is formed on the undermost thin film 33b, the active layer (InGaN) is formed on the N-type semiconductor layer (GaN), and the P⁺ contact layer (GaAs) as the anode electrode 32b is formed on the active layer (InGaN). The blue thin-film LED 3b is formed on the first insulation layer 13 via the conductive layer M.

In each of the LED epitaxial films 300 of the light emitting device 1 of the first embodiment, the thin-film LEDs 3 have the common semiconductor thin film 33. After the LED epitaxial film 300 is formed on the first insulation layer 13, the cathode electrode 40 (i.e., n-side electrode) is formed on the semiconductor thin film 33 as shown in FIG. 1. The cathode electrode 40 is formed at a portion apart from the light emitting layer 31. The anode electrode 32 is connected to the anode wiring 51. The cathode electrode 40 (i.e., the n-side electrode) is connected to the cathode driving circuit 4 via the wire 41.

### <Configuration of Red Thin-Film LED>

FIG. 5B is a schematic sectional view showing the red thin-film LED 3r. As shown in FIG. 5B, the red thin-film LED 3r has a laminate structure, and includes a semiconductor thin film 33r, a light emitting layer 31r and an anode electrode 32r. The anode electrode 32r is firmed of a P⁺ contact layer composed of GaAs. The light emitting layer 31r is formed of three layers: a P-type cladding layer 31_1r composed of p-AlₓGa₁₋ₓAs, an active layer 31_2r composed of n-Al_{y}Ga_{1-y}As, and an N-type cladding layer 31_3r composed of n-Al_{z}Ga_{1-z}As. The semiconductor thin film 33r is composed of two layers: an N⁺ contact layer 33_1r composed of GaAs and an N⁺ joining layer 33_2r composed of GaAs. The red thin-film LED 3r is formed on the first insulation layer 13 via the conductive layer M. Further, the light emitting layer 31r can also include an etching stopper layer 31_4r below the N-type cladding layer 31_3r.

The red thin-film LED 3r is so configured that the light emitting layer 31r is formed on the undermost semiconductor thin film 33r, and the anode electrode 32r is formed on the light emitting layer 31r. The semiconductor thin film 33r is so configured that the N⁺ contact layer 33_1r is formed on the undermost N⁺ joining layer 33_2r. The light emitting layer 31 is so configured that the etching stopper layer 31_4r is formed on the N⁺ contact layer 33_1r, the N-type cladding layer 31_3r is formed on the etching stopper layer 31_4r, the active layer 31_2r is formed on the N-type cladding layer 31_3r, and the P-type cladding layer 31_1r is formed on the active layer 31_2r. The anode electrode 32r is formed on the P-type cladding layer 31_1r. The cathode electrode 40r is formed on the N⁺ contact layer 33_1r of the semiconductor thin film 33r.

The etching stopper layer 31_4r has a function to expose a surface of the N+ contact layer 33_1r when the layers above the etching stopper layer 31_4r are removed by etching during a formation process of the semiconductor light emitting element. Further, the etching stopper layer 31_4r has a function to stop the etching or to lower the etching speed when the layers above the etching stopper layer 31_4r are removed by etching during a formation process of the thin-film LED 3.

As shown in FIG. 2A, the light emitting layer 31 is disposed so that a backside (i.e., a lower side) of the light emitting layer 31 faces the substrate 21 of the light emitting device 1. The light emitting layer 31 emits light from both sides (i.e., both surfaces). Light emitted from the backside (i.e., the lower side) of the light emitting layer 31 is reflected by the metal layer 11, and is emitted through a surface side (i.e., an upper side) of the light emitting layer 31. Therefore, both of the light emitted from the surface side of the light emitting layer 31 and the light emitted from the backside of the light emitting layer 31 can be emitted (as the emission light 30) through a surface side of the semiconductor light emitting portion 10.

### <Advantages>

As described above, according to the first embodiment of the present invention, since the second insulation layer 12 is provided between the first insulation layer 13 and the first metal layer 11a (Al) as shown in FIG. 3, the surface of the first insulation layer 13 can be planarized. Therefore, the thin-film LED 3 can be bonded to the surface of the first insulation layer 13. As a result, a compact light semiconductor light emitting device 1 can be manufactured at low cost.

Further, since the first insulation layer 13 is composed of an organic insulation film and the second insulation layer 12 is composed of an inorganic insulation film, the insulation layers can be formed on the metal layer 11 without forming voids, and it is ensured that the surface of the first insulation layer 13 can be planarized.

Furthermore, since the second metal layer 11b (Ti) is provided between the first metal layer 11a and the substrate 21, diffusion of Al of the first metal layer 11a can be prevented. In this regard, the second metal layer 11b can be composed of other material than Ti. It is possible to use other material having melting point higher than Al and transmitting light.

### SECOND EMBODIMENT.

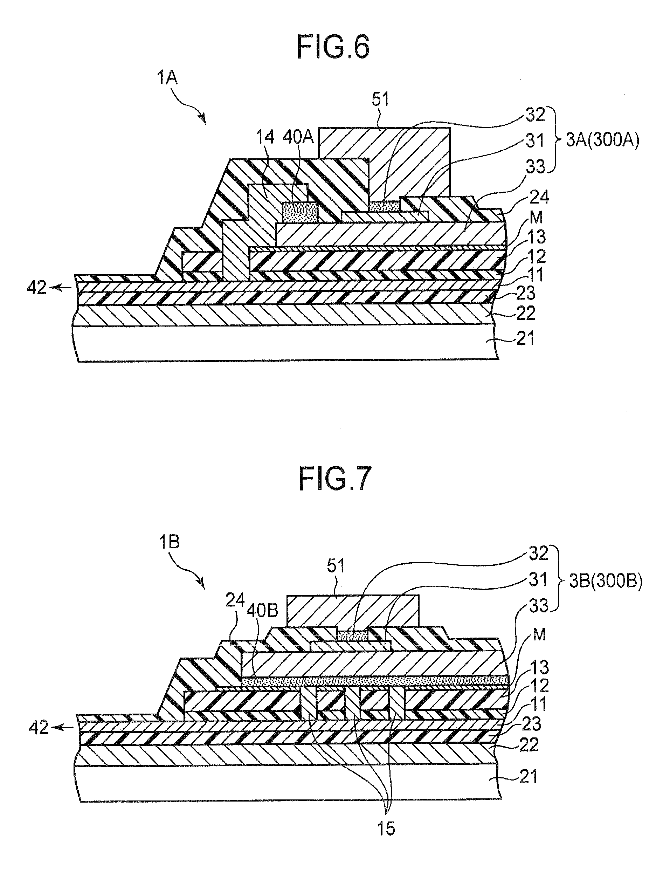

FIG. 6 is a sectional view of a light emitting device 1A according to the second embodiment of the present invention. FIG. 6 corresponds to the sectional view taken along line 2B-2B shown in FIG. 1.

Unlike the light emitting device 1 of the first embodiment, the light emitting device 1A of the second embodiment does not use wire bonding. Instead of the provision of the wire 41, the cathode connection pad 42 of the cathode driving circuit 4 is connected to the metal layer 11, and an internal conductive portion 14 is provided for connecting the metal layer 11 and a cathode electrode 40A of the thin-film LEDs 3. Other components of the light emitting device 1A of the second embodiment, are the same as those of the light emitting device 1 of the first embodiment, and explanations thereof will be omitted.

The internal conductive portion 14 is formed in a through-hole penetrating the second insulation layer 12 and the first insulation layer 13 formed on the metal layer 11. The formation of the internal conductive layer 14 is performed after an LED epitaxial film 300A is bonded to the first insulation layer 13. The internal conductive portion 14 connects the metal layer 11 and the cathode electrode 40A of the thin-film LEDs 3A (i.e., the LED epitaxial film 300A). The LED epitaxial film 300A is bonded to the first insulation layer 13 via the conductive layer M.

According to the light emitting device 1A of the second embodiment, the metal layer 11 functions as a reflection layer that reflects light, and also functions as a current path on the cathode side. That is, the metal layer 11 can substitute the wire 41. Further, heat generated at the light emitting layer 31 is released to the metal layer 11 via the internal conductive portion 14. Therefore, in addition to the advantages of the light emitting device 1 of the first embodiment, heat releasability can be enhanced. Moreover, since wire bonding is not performed, efficiency of wiring around the light emitting portion 10 can be enhanced.

### THIRD EMBODIMENT.

FIG. 7 is a sectional view of a light emitting device 1B according to the third embodiment of the present invention. FIG. 7 corresponds to the sectional view taken along line 2B-2B shown in FIG. 1.

Unlike the light emitting device 1A of the second embodiment, the light emitting device 1B of the third embodiment is configured so that a cathode electrode 40B (i.e., an n-side electrode) is provided at a region below the semiconductor thin film 33 (i.e., the n-side region). The cathode electrode 40B is provided commonly for the thin-film LEDs 3 formed on a LED epitaxial film 300B, as in the first and second embodiments. Further, the light emitting device 1B has penetrating conductive portions 15 that connect the metal layer 11 and the cathode electrode 40B. Other components of the light emitting device 1B of the third embodiment are the Same as those of the light emitting device 1A of the second embodiment, and explanations thereof will be omitted.

The penetrating conductive portions 15 are formed in through-holes that penetrate the first insulation layer 13 and the second insulation layer 12 to reach the surface of the metal layer 11. The through-holes are formed by etching the first insulation layer 13 and the second insulation layer 12. The penetrating conductive portions 15 function as current paths connecting the metal layer 11 and the cathode electrode 40B. The LED epitaxial film 300B is bonded to the first insulation layer 13 via the conductive layer M.

According to the light emitting device 1B of the third embodiment, the cathode electrode 40B (i.e., the n-side electrode) and the penetrating conductive portions 15 are formed below the semiconductor thin film 33 (i.e., the n-side region). Therefore, in addition to the advantages of the light emitting device 1A of the second embodiment, efficiency of wiring around the light emitting portion 10 can be further enhanced.

### HEAD MOUNT DISPLAY DEVICE

The light emitting devices 1, 1A and 1B of the above described embodiments can be applied to a head mount display device.

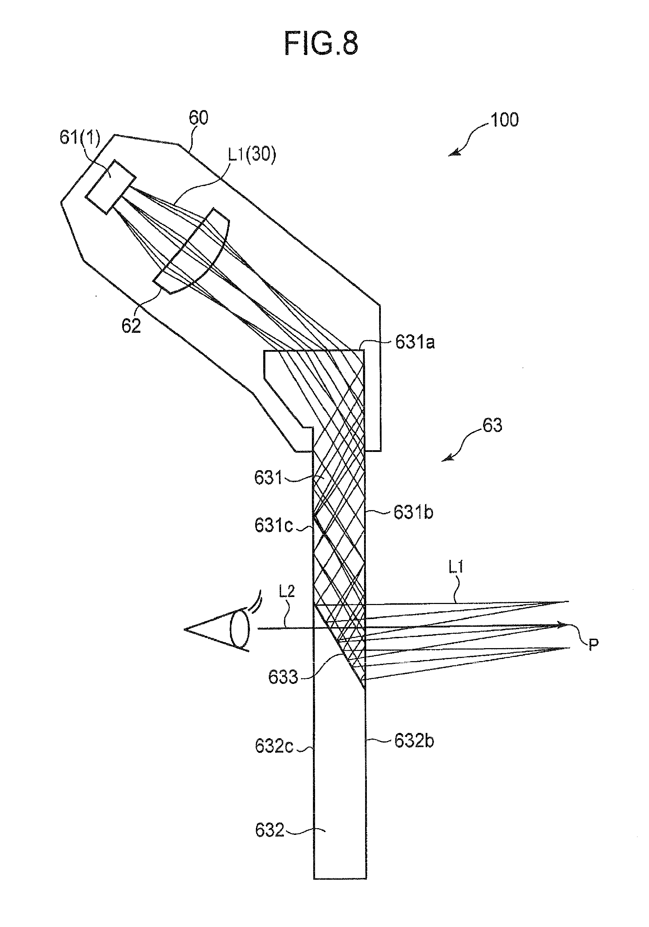

FIG. 8 is a schematic sectional view showing the head mount display device 100 employing the light emitting device 1 according to the first embodiment. The light emitting device 1 includes the light emitting portion 10 having the thin-film LEDs 3 (FIG. 1) as described in the first embodiment. The head mount display device 100 includes a light source 61 (i.e., the light emitting device 1), a condenser lens 62 and a prism 63. The light source 61, the condenser lens 62 and a part of the prism 63 is housed in a casing 60.

The light source 61 is implemented by the light emitting device 1. Emission light 30 emitted by thin-film LEDs 3 (i.e., the red thin-film LED 3r, the blue thin-film LED 3b and the green thin-film LED 3g) is incident on the condenser lens 62 as image light L1. In this regard, it is preferable to provide a microlens array for reducing beam angle of light emitted by the thin-film LEDs 3 toward the condenser lens 62.

The condenser lens 62 is implemented by a cylinder lens that condenses the image light L1 (i.e., the emission light 30) from the light source 61. The image light L1 emitted by the prism 63 forms a virtual image viewed at a focal point P. The focal point P is a point where light is focused.

The prism 63 functions as an observing optical system that guides the image light L1 and external light L2 to the focal point P. The prism 63 includes an upper prism 631, a lower prism 632 and a hologram 633.

The upper prism 631 is implemented by a transparent member. The upper prism 631 totally reflects the light L1 (i.e., the emission light 30) from the condenser lens 62 at inner surfaces to thereby guide the light L1 to the hologram 633, and transmits the external light L2. The upper prism 631 and the lower prism 632 are formed of, for example, acrylic resin such as PMMA (poly methyl methacrylate) in the form of a parallel flat plate. A bottom end of the flat plate is shaped like a wedge, and a top end of the flat plate is made thicker. Further, the upper prism 631 and the lower prism 632 are bonded to each other using adhesive agent so as to sandwich the hologram 633 therebetween.

The upper prism 631 has an upper end surface 631a as an incident surface on which the image light L1 is incident. The upper prism 631 further has surfaces 631b and 631c at front and rear surfaces (i.e., left and right surfaces in FIG. 8), which are parallel to each other. The surface 631b constitutes a total reflection surface reflecting the image light L1 and also constitutes an emitting surface through which the image light L1 is emitted. The surface 631b also constitutes an emitting surface through which the external light L2 is emitted.

The lower prism 632 is implemented by a transparent optical member that transmits the external light L2. The lower prism 632 is bonded to the lower end of the upper prism 631. The lower prism 632 and the upper prism 631 are integrated with each other in the form of substantially parallel flat plate. The lower prism 632 has two surfaces 632b and 632c (front and rear surfaces) which are parallel to each other. The surface 632c constitutes an incident surface on which the external light L2 is incident. The surface 631b and the surface 632b are smoothly connected to each other, and the surface 631c and the surface 632c are smoothly connected to each other.

The upper prism 631 and the lower prism 632 are bonded to each other in the form of substantially parallel flat plate, and therefore a thickness (t) of a portion of the transparent substrate (i.e., the upper prism 631 and the lower prism 632) transmitting the external light L2 is constant. Further, since the upper prism 631 and the lower prism 632 integrally form the substantially parallel flat plate, a refraction of the external light L2 caused when passing the wedge-shaped lower end of the upper prism 631 can be cancelled by the lower prism 632. Therefore, it is possible to prevent distortion of external image observed in a see-through way.

The hologram 633 also functions as a half mirror that reflects the image light L1 incident from the upper prism 631 side, and emits the image light L1 through the surface 631b. Further, the hologram 633 transmits the external light L2 incident from the lower prism 632 side, and emits the external light L2 through the surface 631b. The hologram 632 is preferably of a film type.

In FIG. 8, the image light L1 (of red, green and blue) emitted by the light source 61 is condensed by the condenser lens 62, is incident on the surface 631a of the upper prism 631 of the prism 63, is totally reflected at the surfaces 631b and 631c (facing each other) at least once at each surface, and is incident on the hologram 633. The image light L1 incident on the hologram 633 is reflected by the hologram 633, and is focused at the focal point P. A virtual image formed at the focal point P can be observed by an observer on the opposite side (i.e. the left side in FIG. 8) of the prism 63 to the focal point P.

In the above description, the head mount display 100 has been described as employing the light emitting device 1 of the first embodiment. However, the head mount display 100 can also employ the light emitting device 1A of the second embodiment and the light emitting device 1B the third embodiment.

While the preferred embodiments of the present invention have been illustrated in detail, it should be apparent that modifications and improvements may be made to the invention without departing from the spirit and scope of the invention as described in the following claims.

## Claims

1. A semiconductor light emitting device (1, 1A, 1B) comprising:
a thin-film semiconductor light emitting element (3, 3A, 3B);
a substrate (21);
a first insulation layer (13) having a surface to which said thin-film semiconductor light emitting element (3, 3A, 3B) is bonded;
a first metal layer (11a) composed of aluminum and disposed on a side of said first insulation layer (13) facing said substrate (21), and
a second insulation layer (12) disposed between said first insulation layer (13) and said first metal layer (11a).

2. The semiconductor light emitting device (1, 1A, 1B) according to claim 1, wherein said first insulation layer (13) is composed of an organic insulation film, and said second insulation layer (12) is composed of an inorganic insulation film.

3. The semiconductor light emitting device (1, 1A, 1B) according to claim 1 or 2, wherein said second insulation layer (12) is thinner than said first insulation layer (13).

4. The semiconductor light emitting device (1, 1A, 1B) according to any one of claims 1 to 3, wherein said first insulation layer (13) and said second insulation layer (12) both transmit light.

5. The semiconductor light emitting device (1, 1A, 1B) according to any one of claims 1 to 4, wherein said thin-film semiconductor light emitting element (3, 3A, 3B) is bonded to said first insulation layer (13) by means of hydrogen bonding.

6. The semiconductor light emitting device (1, 1A, 1B) according to any one of claims 1 to 5, wherein said surface of said first insulation layer (13) has a surface roughness lower than or equal to 20 nm.

7. The semiconductor light emitting device (1, 1A, 1B) according to any one of claims 1 to 6, wherein a sum of thicknesses of said first insulation layer (13) and said second insulation layer (12) is in a range from 1.5 µm to 1.7 µm.

8. The semiconductor light emitting device (1A, 1B) according to any one of claims 1 to 7, further comprising a conductive portion (14, 15) that penetrates said first insulation layer (13) and said second insulation layer (12) so as to connect said semiconductor light emitting element (3A, 3B) and said first metal layer (11a).

9. The semiconductor light emitting device (1, 1A, 1B) according to any one of claims 1 to 8, further comprising a second metal layer (11b) disposed between said first metal layer (11a) and said substrate (21),
wherein said second insulation layer (12) is disposed on a surface of said first metal layer (11a) facing away from said substrate (21).

10. The semiconductor light emitting device (1, 1A, 1B) according to claim 9, wherein said second metal layer (11b) is composed of titanium.

11. The semiconductor light emitting device (1, 1A, 1B) according to claim 9, wherein an integrated circuit (22) is formed on said substrate (21), and
wherein said first metal layer (11a) and said second metal layer (11b) are formed on said integrated circuit (22) via a base insulation layer (23).

12. The semiconductor light emitting device (1, 1A, 1B) according to any one of claims 1 to 11, wherein said thin-film semiconductor light emitting element (3, 3A, 3B) is directly bonded to said first insulation layer (13), or bonded to said first insulation layer (13) via a conductive layer (M).

13. A head mount display device (100) comprising said semiconductor light emitting device (1, 1A, 1B) according to any one of claims 1 to 12.
